# EUROPEAN PATENT APPLICATION

(11) **EP 4 539 648 A1**
(43) Date of publication of application: **16.04.2025**
(21) Application number: 23827087.0
(22) Date of filing: 14.06.2023
(51) Int. Cl.: H10N 10/13, H02N 11/00, H10N 10/01, H10N 10/17

(54) **THERMOELECTRIC CONVERSION MODULE AND PRODUCTION METHOD FOR SAME**

(30) Priority: 24.06.2022 JP 2022102077
(71) Applicant: Denka Company Limited, Tokyo 103-8338 (JP)
(72) Inventor: ASAMI, Takeshi, Tokyo 103-8338 (JP); NIWA, Ryota, Tokyo 103-8338 (JP); MAEDA, Ryota, Tokyo 103-8338 (JP)
(74) Representative: Gulde & Partner
(86) International application number: PCT/JP2023/022119
(87) International publication number: WO 2023/248901

(57) **Abstract**

The thermoelectric conversion module includes a substrate having a first main face and a second main face, a thermoelectric conversion part located on the first main face, a first thermal conduction part and a second thermal conduction part located on the second main face, and a thermal insulating member located on the second main face. The thermoelectric conversion part has a p-type thermoelectric conversion element and an n-type thermoelectric conversion element, a first end part of the p-type thermoelectric conversion element is in contact with a first end part of the n-type thermoelectric conversion element, the first thermal conduction part is overlapped with a second end part of the p-type thermoelectric conversion element, the second thermal conduction part is overlapped with a second end part of the n-type thermoelectric conversion element, each thickness of the n-type thermoelectric conversion element and the p-type thermoelectric conversion element is 3 µm or more and 30 µm or less, each of a difference in linear expansion coefficient between the first thermal conduction part and the thermal insulating member and a difference in linear expansion coefficient between the second thermal conduction part and the thermal insulating member is 100 ppm/K or less.

## Description

### Technical Field

The present disclosure relates to a thermoelectric conversion module and a production method for the same.

### Background Art

A thermoelectric conversion element may be used to perform power generation using geothermal heat, exhaust heat of a factory, or the like. Patent Document 1 discloses an embodiment in which a flexible substrate having a pattern layer composed of resin layers and metal layers is provided on both surfaces of a thermoelectric conversion module having a P-type thermoelectric element material and an N-type thermoelectric element material. In Patent Document 1, a metal layer included in one flexible substrate overlaps one electrode included in the thermoelectric conversion module, and a metal layer included in the other flexible substrate overlaps the other electrode included in the thermoelectric conversion module. In the above embodiment, by setting one flexible substrate to a high temperature state and setting the other flexible substrate to a low temperature state, a temperature difference is generated in a planar direction of the thermoelectric conversion module. Accordingly, an electromotive force is generated in the thermoelectric conversion module.

### Citation List

### Patent Literature

[Patent Document 1] Japanese Patent No. 4,895,293

### Summary of Invention

### Technical Problem

In order to improve output of the thermoelectric conversion module as described in Patent Document 1, for example, it is conceivable to increase thermoelectric conversion efficiency by increasing the temperature difference. In order to increase the temperature difference in Patent Document 1, for example, the P-type thermoelectric element material and the N-type thermoelectric element material may be thinned, and the distance between the metal layers may be increased. However, in the former case, the thinner the thickness of each thermoelectric element material is, the higher the electrical resistance of each thermoelectric element material is. In the latter case, as the distance between the metal layers increase, the number of elements per unit area is decreased. For this reason, if the temperature difference is simply increased, output of the thermoelectric conversion module per unit area may rather decrease.

In addition, for stable output of the power generated in the thermoelectric conversion module regardless of the temperature of a heat source, maintaining of the shape of the thermoelectric conversion module and preventing occurring the variation in the temperature difference are conceivable. Here, the larger the distance to increase the temperature difference, the more difficult it becomes to maintain the shape of the thermoelectric conversion module. Moreover, in the thermoelectric conversion module described in Patent Document 1, the temperature of the part to be in the low temperature state is particularly unstable, and there is a tendency for occurrence of the variation in the temperature difference of the thermoelectric conversion module in the planar direction.

An object of one aspect of the present disclosure is to provide a thermoelectric conversion module capable of improving output per unit area and of stable output and a method for manufacturing the same.

### Solution to Problem

A thermoelectric conversion module and a method for manufacturing the same according to one aspect of the present disclosure are as follows.
[1] A thermoelectric conversion module includes a substrate having a first main face and a second main face located opposite the first main face, a thermoelectric conversion part located on the first main face, a first thermal conduction part and a second thermal conduction part located on the second main face and adjacent to each other along a first direction orthogonal to a thickness direction of the substrate, and a thermal insulating member located on the second main face and at least between the first thermal conduction part and the second thermal conduction part, wherein the thermoelectric conversion part has a p-type thermoelectric conversion element and an n-type thermoelectric conversion element arranged along the first direction, a first end part of the p-type thermoelectric conversion element in the first direction is in contact with a first end part of the n-type thermoelectric conversion element in the first direction and overlaps with the thermal insulating member in the thickness direction, in the thickness direction, the first thermal conduction part is overlapped with a second end part of the p-type thermoelectric conversion element in the first direction, in the thickness direction, the second thermal conduction part is overlapped with a second end part of the n-type thermoelectric conversion element in the first direction, each thickness of the p-type thermoelectric conversion element and the n-type thermoelectric conversion element is 3 µm or more and 30 µm or less, and each of a difference in linear expansion coefficient between the first thermal conduction part and the thermal insulating member and a difference in linear expansion coefficient between the second thermal conduction part and the thermal insulating member is 100 ppm/K or less.
[2] The thermoelectric conversion module according to [1], wherein each linear expansion coefficient of the first thermal conduction part and the second thermal conduction part is 100 ppm/K or more and 200 ppm/K or less, and the linear expansion coefficient of the thermal insulating member is 200 ppm/K or less.
[3] The thermoelectric conversion module according to [1] or [2], wherein each width of the first thermal conduction part and the second thermal conduction part along the first direction is 0.5 mm or more and 1.5 mm or less.
[4] The thermoelectric conversion module according to any one of [1] to [3], wherein each thermal conductivity of the first thermal conduction part and the second thermal conduction part is 2.0 W/mK or more and 5.0 W/mK or less, and the thermal conductivity of the thermal insulating member is 0.02 W/mK or more and 0.05 W/mK or less.
[5] The thermoelectric conversion module according to any one of [1] to [4] further includes a heat dissipation member located on the second main face, wherein as viewed from the thickness direction, the heat dissipation member surrounds the first thermal conduction part, the second thermal conduction part and the thermal insulating member.
[6] The thermoelectric conversion module according to any one of [1] to [5], wherein each thickness of the p-type thermoelectric conversion element and the n-type thermoelectric conversion element is 5 µm or more and 25 µm or less, and an interval between the first thermal conduction part and the second thermal conduction part in the first direction is 3 mm or more and less than 12 mm.
[7] The thermoelectric conversion module according to any one of [1] to [6] further includes a first thermoelectric conversion group located on the first main face and having the thermoelectric conversion part, and a second thermoelectric conversion group located on the first main face and adjacent to the first thermoelectric conversion group along a second direction orthogonal to the thickness direction and the first direction, wherein the second thermoelectric conversion group has a second thermoelectric conversion part adjacent to the thermoelectric conversion part along the second direction, the second thermoelectric conversion part has a second p-type thermoelectric conversion element and a second n-type thermoelectric conversion element arranged along the first direction, a first end part of the second p-type thermoelectric conversion element in the first direction is in contact with a first end part of the second n-type thermoelectric conversion element in the first direction and overlaps with the thermal insulating member in the thickness direction, the first thermal conduction part and the second thermal conduction part each extend along the second direction, in the thickness direction, the first thermal conduction part is overlapped with a second end part of the second n-type thermoelectric conversion element included in the second thermoelectric conversion part in the first direction, and in the thickness direction, the second thermal conduction part is overlapped with a second end part of the second p-type thermoelectric conversion element included in the second thermoelectric conversion part in the first direction.
[8] The thermoelectric conversion module according to [7] further includes a first conductive part located on the first main face and connected to one end of the first thermoelectric conversion group in the first direction, and a second conductive part located on the first main face and connected to the other end of the first thermoelectric conversion group in the first direction and to one end of the second thermoelectric conversion group in the first direction, wherein each conductivity type of the first conductive part and the second conductive part is identical.
[9] The thermoelectric conversion module according to any one of [1] to [8], wherein each of the substrate, the thermoelectric conversion part, the first thermal conduction part, the second thermal conduction part and the thermal insulating member has a flexibility.
[10] A method for manufacturing a thermoelectric conversion module includes a first step of forming a first thermal conduction part, a second thermal conduction part and a thermal insulating member on one main face of a substrate, a second step of forming a first layer including a p-type thermoelectric conversion material on the other main face of the substrate, a third step of forming a p-type thermoelectric conversion layer by immersing the other main face of the substrate in an organic solvent after the second step, and a fourth step of forming a p-type thermoelectric conversion element and an n-type thermoelectric conversion element in a part of the p-type thermoelectric conversion layer by dripping a dopant solution on the part after the third step, wherein the first thermal conduction part and the second thermal conduction part are adjacent to each other along a first direction orthogonal to a thickness direction of the substrate, a first end part of the p-type thermoelectric conversion element in the first direction is in contact with a first end part of the n-type thermoelectric conversion element in the first direction and overlaps with the thermal insulating member in the thickness direction, in the thickness direction, the first thermal conduction part is overlapped with a second end part of the p-type thermoelectric conversion element in the first direction, in the thickness direction, the second thermal conduction part is overlapped with a second end part of the n-type thermoelectric conversion element in the first direction, and each of a difference in linear expansion coefficient between the first thermal conduction part and the thermal insulating member and a difference in linear expansion coefficient between the second thermal conduction part and the thermal insulating member is 100 ppm/K or less.

### Advantageous Effects of Invention

According to one aspect of the present disclosure, a thermoelectric conversion module capable of improving output per unit area and of stable output and a method for manufacturing the same can be provided.

### Brief Description of Drawings

[FIG. 1] (a) of FIG. 1 is a schematic plan view illustrating a thermoelectric conversion module according to an embodiment, and (b) of FIG. 1 is a schematic bottom view illustrating the thermoelectric conversion module according to an embodiment.
[FIG. 2] (a) of FIG. 2 is an enlarged view of a part (a region surrounded by an alternate long and short dash line) of (a) of FIG. 1, and (b) of FIG. 2 is a cross-sectional view taken along line IIb-IIb of (a) of FIG. 2.
[FIG. 3] (a) and (b) of FIG. 3 are views for describing a method for manufacturing a thermoelectric conversion module according to an embodiment.
[FIG. 4] (a) and (b) of FIG. 4 are views for describing a method for manufacturing a thermoelectric conversion module according to an embodiment.
[FIG. 5] (a) and (b) of FIG. 5 are views for describing a method for manufacturing a thermoelectric conversion module according to an embodiment.
[FIG. 6] FIG. 6 is a schematic cross-sectional view illustrating a part of a thermoelectric conversion module in a deformation.
[FIG. 7] (a) of FIG. 7 is a schematic bottom view illustrating a thermoelectric conversion module according to a modification, and (b) of FIG. 7 is a schematic cross-sectional view taken along line VIIb-VIIb of (a) of FIG. 7.

### Description of Embodiments

Hereinafter, an embodiment of the present disclosure will be described in detail with reference to the accompanying drawings. In the following description, the same reference numerals are used for the same element or element having the same function, and redundant description is omitted. In the present specification, "identical" and words similar thereto are not limited to "completely identical".

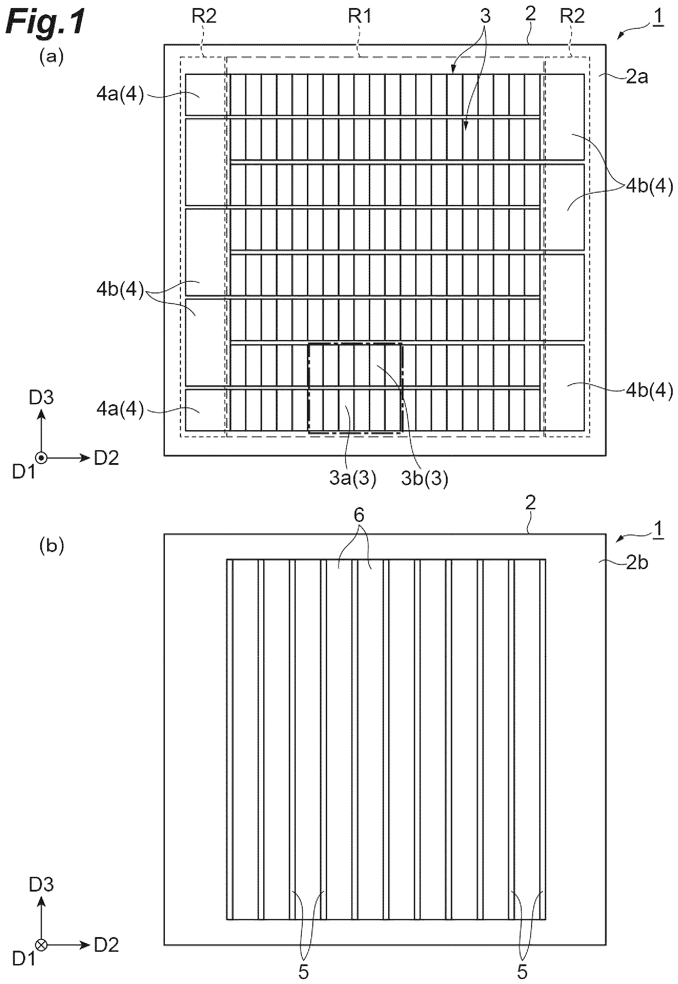

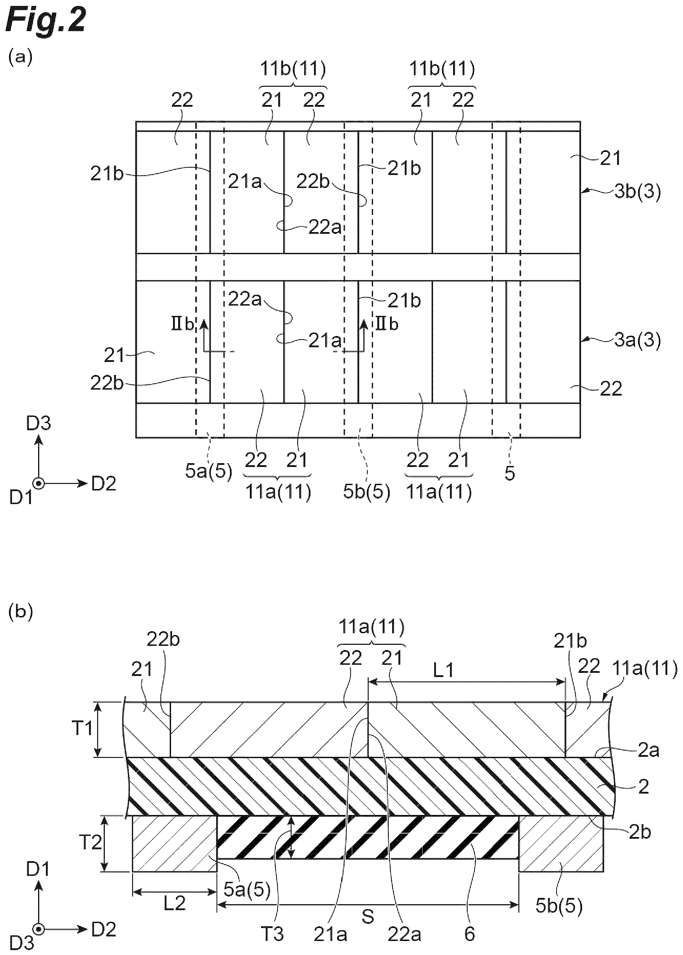

First, a configuration of a thermoelectric conversion module according to the present embodiment will be described with reference to FIGS. 1 and 2. (a) of FIG. 1 is a schematic plan view showing the thermoelectric conversion module according to the present embodiment, and (b) of FIG. 1 is a schematic bottom view showing the thermoelectric conversion module according to the present embodiment. (a) of FIG. 2 is an enlarged view of a part (a region surrounded by an alternate long and short dash line) of (a) of FIG. 1. (b) of FIG. 2 is a cross-sectional view taken along line IIb-IIb of (a) of FIG. 2.

A thermoelectric conversion module 1 shown in (a) and (b) of FIG. 1 is a device capable of generating power by being supplied with heat from the outside. The thermoelectric conversion module 1 is a so-called in-plane type device. Thus, the thermoelectric conversion module 1 is likely to be more excellent in workability and flexibility than, for example, a π-type element (cross-plane type element). Therefore, the thermoelectric conversion module 1 can be provided along the side surface of a cylindrical pipe or the like used for recovering factory exhaust heat, for example. That is, the thermoelectric conversion module 1 can be easily disposed at various positions. Therefore, the thermoelectric conversion module 1 is used, for example, as a power source for a plant sensor using exhaust heat. In addition, the contact resistance between the thermoelectric conversion material and the electrode included in the thermoelectric conversion module 1 is likely to be lower than that of the π-type module. In the following, the temperature of each component of the thermoelectric conversion module 1 is measured under natural convection conditions of air.

The thermoelectric conversion module 1 includes a substrate 2, a plurality of thermoelectric conversion groups 3, a plurality of conductive parts 4, a plurality of thermal conduction parts 5 and a plurality of thermal insulating members 6. At least one of the substrate 2, the plurality of thermoelectric conversion groups 3, the plurality of conductive parts 4, the plurality of thermal conduction parts 5 and the plurality of thermal insulating members 6 shows a flexibility.

The substrate 2 is a sheet member made of a resin showing heat resistance and flexibility, and, for example, has a substantially flat plate shape. Examples of the resin constituting the substrate 2 include a (meth)acrylic based resin, a (meth)acrylonitrile based resin, a polyamide based resin, a polycarbonate based resin, a polyether based resin, a polyester based resin, an epoxy based resin, an organosiloxane based resin, a polyimide based resin and a polysulfone based resin. The thickness of the substrate 2 is, for example, 5 µm or more and 50 µm or less. The thermal conductivity of the substrate 2 is, for example, 0.1 W/mK (corresponding to 0.1 watts per meter per Kelvin and 0.1 W×m⁻¹×K⁻¹) or more and 0.3 W/mK or less. The thermal conductivity of the substrate 2 is 0.3 W/mK or less, so that a temperature difference can occur inside the thermoelectric conversion group 3. The thermal conductivity of the substrate 2 is measured by a steady state method or a non-steady state method.

The substrate 2 has a first main face 2a and a second main face 2b located on the opposite side of the first main face 2a. The first main face 2a and the second main face 2b are surfaces intersecting with a direction along the thickness of the substrate 2. The shapes of the first main face 2a and the second main face 2b is not particularly limited, and are, for example, a polygonal shape, a circular shape, an elliptical shape or the like. Hereinafter, a direction along the thickness of the substrate 2 is simply referred to as a thickness direction D1. Viewing from the thickness direction D1 corresponds to a plan view. Further, directions orthogonal to the thickness direction D1 are referred to as a first direction D2 and a second direction D3.

A thermoelectric conversion region R1 and two conductive regions R2 are defined on the first main face 2a. The plurality of thermoelectric conversion groups 3 are provided in the thermoelectric conversion region R1. The plurality of conductive parts 4 are provided in each conductive region R2. The thermoelectric conversion region R1 is located between the two conductive regions R2 in the first direction D2. The higher the percentage of the thermoelectric conversion region R1 occupied on the first main face 2a, the higher output of the thermoelectric conversion module 1 is likely to be. In a plan view, the thermoelectric conversion region R1 accounts for, for example, 50% or more and 90% or less, in the area of the first main face 2a. In a plan view, the two conductive regions R2 accounts for, for example, 5% or more and 30% or less, in the area of the first main face 2a. In this case, the thermoelectric conversion module 1 can exhibit excellent output while reliably forming a conductive path connecting the thermoelectric conversion groups 3 to each other.

Each of the plurality of thermoelectric conversion groups 3 is a portion capable of generating power by being supplied with heat from the outside, and is located on the first main face 2a. The thermoelectric conversion groups 3 extend along the first direction D2 and are arranged along the second direction D3. Each of the thermoelectric conversion groups 3 has a band shape when viewed from the thickness direction D1. Each thermoelectric conversion group 3 is electrically connected to each other in series while being spaced apart from each other. In the first direction D2, one end of each thermoelectric conversion group 3 is connected to one of the plurality of conductive parts 4 included in one conductive region R2, and the other end of each thermoelectric conversion group 3 is connected to one of the plurality of conductive parts 4 included in the other conductive region R2. Each of the plurality of thermoelectric conversion groups 3 includes a plurality of thermoelectric conversion parts 11. In the present embodiment, each thermoelectric conversion group 3 includes ten thermoelectric conversion parts 11, but is not limited thereto. In each thermoelectric conversion group 3, the plurality of thermoelectric conversion parts 11 are arranged along the first direction D2. Two thermoelectric conversion parts 11 adjacent to each other in the first direction D2 are in contact with each other and are connected in series.

Hereinafter, one thermoelectric conversion group 3 of the two thermoelectric conversion groups 3 illustrated in (a) of FIG. 2 may be referred to as a first thermoelectric conversion group 3a, and the other thermoelectric conversion group 3 adjacent to the first thermoelectric conversion group 3a along the second direction D3 may be referred to as a second thermoelectric conversion group 3b. Further, the thermoelectric conversion part 11 included in the first thermoelectric conversion group 3a may be referred to as a first thermoelectric conversion part 11a, and the thermoelectric conversion part 11 included in the second thermoelectric conversion group 3b may be referred to as a second thermoelectric conversion part 11b. A plurality of the first thermoelectric conversion parts 11a included in the first thermoelectric conversion group 3a is arranged in order along the first direction D2, a plurality of the second thermoelectric conversion parts 11b included in the second thermoelectric conversion group 3b is arranged in order along the first direction D2. The first thermoelectric conversion part 11a and the second thermoelectric conversion part 11b are adjacent to each other along the second direction D3.

Each of the plurality of thermoelectric conversion parts 11 is a part in which thermoelectric conversion is performed in the thermoelectric conversion module 1, and has a flexibility. The shape of the thermoelectric conversion part 11 in a plan view is not particularly limited, and is, for example, a polygonal shape, a circular shape, an elliptical shape or the like. A p-type thermoelectric conversion element 21 and an n-type thermoelectric conversion element 22 have an identical shape as each other, but are not limited thereto. Each thermoelectric conversion part 11 has the p-type thermoelectric conversion element 21 and the n-type thermoelectric conversion element 22 arranged along the first direction D2. In each thermoelectric conversion part 11, a first end part 21a of the p-type thermoelectric conversion element 21 in the first direction D2 and a first end part 22a of the n-type thermoelectric conversion element 22 in the first direction D2 are in contact with each other. In each thermoelectric conversion part 11, a second end part 21b of the p-type thermoelectric conversion element 21 in the first direction D2 is located at one end of the corresponding thermoelectric conversion part 11, and a second end part 22b of the n-type thermoelectric conversion element 22 in the first direction D2 is located at the other end of the corresponding thermoelectric conversion part 11. In two thermoelectric conversion parts 11 adjacent to each other in the first direction D2, the second end part 21b of the p-type thermoelectric conversion element 21 included in one thermoelectric conversion part 11 and the second end part 22b of the n-type thermoelectric conversion element 22 included in the other thermoelectric conversion part 11 are in contact with each other.

In each of the plurality of thermoelectric conversion groups 3, the p-type thermoelectric conversion element 21 and the n-type thermoelectric conversion element 22 are alternately arranged in the first direction D2. As shown in (a) of FIG. 2, in the present embodiment, the p-type thermoelectric conversion element 21 of the first thermoelectric conversion part 11a is adjacent to the n-type thermoelectric conversion element 22 (a second n-type thermoelectric conversion element) of the second thermoelectric conversion part 11b in the second direction D3, and the n-type thermoelectric conversion element 22 of the first thermoelectric conversion part 11a is adjacent to the p-type thermoelectric conversion element 21 (a second p-type thermoelectric conversion element) of the second thermoelectric conversion part 11b in the second direction D3.

The p-type thermoelectric conversion element 21 is provided on the first main face 2a of the substrate 2 and in contact with the n-type thermoelectric conversion element 22. The thickness T1 of the p-type thermoelectric conversion element 21 is, for example, 3 µm or more and 30 µm or less. Since the thickness T1 is 3 µm or more, the electric resistance of the p-type thermoelectric conversion element 21 can be favorably reduced. Since the thickness T1 is 30 µm or less, a temperature gradient can be easily formed inside the p-type thermoelectric conversion element 21. The thickness T1 may be 5 µm or more, 8 µm or more, 10 µm or more, 25 µm or less, 20 µm or less, or 15 µm or less. The length L1 of the p-type thermoelectric conversion element 21 in the first direction D2 is, for example, 2 mm or more and 10 mm or less. In this case, a temperature gradient can be easily formed inside the p-type thermoelectric conversion element 21. The length of the p-type thermoelectric conversion element 21 in the second direction D3 is, for example, 5 mm or more and 30 mm or less. In this case, a sufficient number of thermoelectric conversion parts 11 can be formed on the first main face 2a. The thermal conductivity of the p-type thermoelectric conversion element 21 in the in-plane direction is, for example, 0.01 W/mK or more and 40.0 W/mK or less. The thermal conductivity of the p-type thermoelectric conversion element 21 in the in-plane direction is measured by, for example, an optical alternating current method or a 3-omega method. The p-type thermoelectric conversion element 21 is formed by, for example, various dry methods or wet methods. Examples of the wet method include a doctor blade method, a dip coating method, a spray coating method, a spin coating method, and an ink jet method or the like.

The p-type thermoelectric conversion element 21 is, for example, a p-type semiconductor layer. The p-type thermoelectric conversion element 21 includes, for example, carbon nanotubes (CNTs) and conductive resin different from the carbon nanotubes. The carbon nanotube exhibits p-type. The carbon nanotube may be single-walled, double-walled or multi-walled. From the viewpoint of the electrical conductivity of the p-type thermoelectric conversion element 21, single-walled carbon nanotubes (SWCNTs) may be used. The percentage of the single-walled carbon nanotubes in the total amount of the carbon nanotubes may be 25% by mass or more, 50% by mass or more, or 100% by mass. The diameter of the single-walled carbon nanotube is not particularly limited, and is, for example, 20 nm or less, 10 nm or less, or 3 nm or less. The lower limit of the diameter of the single-walled carbon nanotube is also not particularly limited, but may be 0.4 nm or more, or may be 0.5 nm or more. The thermal conductivity of the carbon nanotube is, for example, 30 W/mK or more and 40 W/mK or less.

In the present specification, the diameter of the single-walled carbon nanotube can be determined by formula: "Diameter (nm) = 248/ω" using the wave number (ω (cm⁻¹)) of a peak appearing at 100 to 300 cm⁻¹ by Raman spectroscopy. As a method for evaluating the single-walled carbon nanotube, a G/D ratio in laser Raman spectroscopy is known. In the present embodiment, the G/D ratio of the single-walled carbon nanotube in laser Raman spectroscopy at a wavelength of 532 nm may be 10 or more or 20 or more. By using such a single-walled carbon nanotube, there is a tendency that the p-type thermoelectric conversion element 21 having further excellent electrical conductivity is obtained. Note that, the upper limit of the G/D ratio is not particularly limited, and may be, 500 or less or 300 or less.

The content of the carbon nanotubes in the p-type thermoelectric conversion element 21 may be, for example, 20 parts by mass or more, 30 parts by mass or more, 40 parts by mass or more, 99 parts by mass or less, 95 parts by mass or less, or 90 parts by mass or less, with respect to 100 parts by mass of the material (p-type thermoelectric conversion material) configuring the p-type thermoelectric conversion element 21.

The conductive resin of the present embodiment is not particularly limited, and a known conductive resin can be used without particular limitation. Examples of the conductive resin include those including a polyaniline-based conductive resin, a polythiophene-based conductive resin, a polypyrrole -based conductive resin, a polyacetylene-based conductive resin, a polyphenylene-based conductive resin, a polyphenylenevinylene-based conductive resin and the like. As the polythiophene-based conductive resin, poly (3, 4-ethylenedioxythiophene) (PEDOT) can be exemplified. In the present embodiment, the conductive resin includes PEDOT and an electron acceptor. In this case, there is a tendency that the electrical conductivity of the p-type thermoelectric conversion element 21 is further enhanced. Examples of the electron acceptor include polystyrene sulfonic acid, polyvinyl sulfonic acid, poly (meth)acrylic acid, polyvinyl sulfonic acid, toluenesulfonic acid, dodecylbenzenesulfonic acid, camphorsulfonic acid, bis(2-ethylhexyl) sulfosuccinate, chlorine, bromine, iodine, phosphorus pentafluoride, arsenic pentafluoride, boron trifluoride, hydrogen chloride, sulfuric acid, nitric acid, tetrafluoroboric acid, perchloric acid, iron(III) chloride, tetracyanoquinodimethane and the like. In view of the electrical conductivity of the p-type thermoelectric conversion element 21, the electron acceptor may be polystyrene sulfonic acid (PSS).

In the p-type thermoelectric conversion element 21, the carbon nanotube and the conductive resin may aggregate. The p-type thermoelectric conversion element 21 may include a porous structure in which carbon nanotubes are bonded to each other by the conductive resin.

The n-type thermoelectric conversion element 22 is provided on the first main face 2a of the substrate 2 and is in contact with the p-type thermoelectric conversion element 21. The thickness of the n-type thermoelectric conversion element 22 is identical to or substantially identical to the thickness T1 of the p-type thermoelectric conversion element 21. The length of the n-type thermoelectric conversion element 22 in the first direction D2 is identical to or substantially identical to the length L1 of the p-type thermoelectric conversion element 21. The length of the n-type thermoelectric conversion element 22 in the second direction D3 is, for example, 2 mm or more and 10 mm or less. In this case, a sufficient number of thermoelectric conversion parts 11 can be formed on the first main face 2a. The thermal conductivity of the n-type thermoelectric conversion element 22 in the in-plane direction is, for example, 0.01 W/mK or more and 40.0 W/mK or less. The thermal conductivity of the n-type thermoelectric conversion element 22 in the in-plane direction is measured by, for example, an optical alternating current method or a 3-omega method. As same as the p-type thermoelectric conversion element 21, the n-type thermoelectric conversion element 22 is formed by, for example, various dry methods or wet methods.

The n-type thermoelectric conversion element 22 is, for example, an n-type semiconductor layer. The n-type thermoelectric conversion element 22 includes, for example, a composite of a plurality of organic substances or a composite of an inorganic substance and an organic substance. In the present embodiment, the n-type thermoelectric conversion element 22 is a portion that exhibits n-type by including a dopant in the p-type thermoelectric conversion element 21. Therefore, the n-type thermoelectric conversion element 22 includes a carbon nanotube, a conductive resin and a dopant. In the present embodiment, dopant means a substance which changes a Seebeck coefficient of a portion to be doped with the dopant. The expression "changing a Seebeck coefficient" means decreasing a Seebeck coefficient value or changing a Seebeck coefficient value from a positive value to a negative value. A thermoelectric conversion material having a positive Seebeck coefficient value has p-type conductivity, and a thermoelectric conversion material having a negative Seebeck coefficient value has an n-type material.

The dopant of the present embodiment, for example, contains: a coordination compound capable of dissociating into an anion that is a complex ion (hereinafter, also simply referred to as "anion") and an alkali metal cation (hereinafter, also simply referred to as "cation"); and a cation scavenger (hereinafter, also simply referred to as "scavenger"). Within the n-type thermoelectric conversion element 22, at least a part of the coordination compound may be dissociated into the anion and the cation. In this case, the cation may be captured by the scavenger. The dopant may contain plural kinds of at least one of a coordination compound and a scavenger. In the portion where the p-type thermoelectric conversion element 21 contains the dopant, the Seebeck coefficient changes. As a result, the n-type thermoelectric conversion element 22 is formed in the above portion.

The reason why the above-described effect is exhibited is not particularly limited, and as one of the causes it is conceivable that the scavenger contained in the dopant captures the cation to dissociate the anion and the anion changes a carrier of the carbon nanotube from a hole to an electron. At this time, in the present embodiment, since the anion is a complex ion having a metal atom at the center, it is conceivable that the n-type conversion is significantly performed by an interaction between the metal atom and the carbon nanotube. It is also conceivable to exhibit the above-described effect because the ionic size of the complex ion is large so that the dissociation of the complex ion from the cation captured by the scavenger is favorable. In the dopant of the present embodiment, the anion is a complex ion. Thus, the n-type thermoelectric conversion element 22 contains the metal atom derived from the complex ion. Therefore, in the present embodiment, the metal atom remaining in the n-type thermoelectric conversion element 22 can function as an antioxidant.

The complex ion (anion) obtained by dissociation of the coordination compound may be selected from the group consisting of ferrocyanide ions, ferricyanide ions, tetrachloroferrate(III) ions, tetrachloroferrate(II) ions, tetracyanonickelate(II) ions, tetrachloronickelate(II) ions, tetracyanocobaltate(II) ions, tetrachlorocobaltate(II) ions, tetracyanocuprate(I) ions, tetrachlorocuprate(II) ions, hexacyanochromate(III) ions, tetrahydroxidozincate(II) ions and tetrahydroxidoaluminate(III) ions. In the above-described group, ferrocyanide ions is preferable. When the anion is ferrocyanide ions, a material having more favorable characteristics is obtained. Furthermore, when the anion is a ferrocyanide ion, there are tendencies that the iron atom remaining in the n-type thermoelectric conversion element 22 suitably functions as an antioxidant, that a change in physical properties over time is further suppressed and that the storage stability is further improved.

The anion may include an iron atom. That is, the coordination compound may include the iron atom. In this case, the anion may be selected, for example, from the group consisting of ferrocyanide ions, ferricyanide ions, tetrachloroferrate(III) ions and tetrachloroferrate(II) ions. In view of the characteristics of the n-type thermoelectric conversion element 22, the anion including the iron atom may be ferrocyanide ions. From the viewpoint of the antioxidant effect, the content of the iron atom in the n-type thermoelectric conversion element 22 may be 0.001% by mass or more and 15% by mass or less, may be 0.005% by mass or more and 12% by mass or less, or may be 0.01% by mass or more and 10% by mass or less. The content of the iron atom in the n-type thermoelectric conversion element 22 indicates a value measured by, for example, ICP emission spectrometry.

The coordination compound may be a complex salt. Examples of the complex salt include potassium ferrocyanide, sodium ferrocyanide, potassium ferricyanide, sodium ferricyanide, potassium tetrachloroferrate(III), sodium tetrachloroferrate(III), potassium tetrachloroferrate(II), sodium tetrachloroferrate(II) and the like. The complex salt may be a hydrate.

Examples of the alkali metal cation obtained by dissociation of the coordination compound include a sodium ion, a potassium ion, a lithium ion and the like. The coordination compound preferably includes at least one of a ferrocyanide compound and a ferricyanide compound.

The cation scavenger is not particularly limited as long as it is a substance which is capable of taking in a cation. Examples of the cation scavenger include a crown ether-based compound, cyclodextrin, calixarene, ethylenediaminetetraacetate, porphyrin, phthalocyanine, derivatives thereof and the like. In the present embodiment, the cation scavenger is a crown ether-based compound. Examples of the crown ether-based compound include 15-crown-5-ether, 18-crown-6-ether, 12-crown-4-ether, benzo-18-crown-6-ether, benzo-15-crown-5-ether, benzo-12-crown-4-ether and the like. The ring size of the crown ether used as the scavenger may be selected in accordance with the size of the metal ion to be taken in. For example, in a case where the metal ion is a potassium ion, the crown ether-based compound may be an 18-membered ring crown ether. In a case where the metal ion is a sodium ion, the crown ether-based compound may be a 15-membered ring crown ether. In a case where the metal ion is a lithium ion, the crown ether-based compound may be a 12-membered ring crown ether.

The crown ether-based compound may contain a benzene ring. In this case, the stability of the crown ether-based compound may be improved. Examples of the crown ether-based compound having a benzene ring include benzo-18-crown-6-ether, benzo-15-crown-5-ether, benzo-12-crown-4-ether and the like.

A molar ratio (C₂/C₁) of a content C₂ of the scavenger with respect to a content C₁ of the cation may be 0.1 or more and 5 or less, 0.3 or more and 3 or less, or 0.5 or more and 2 or less.

In each of the plurality of thermoelectric conversion parts 11, a mass percentage of the carbon nanotubes in the total mass of the thermoelectric conversion part 11 is, for example, 30% or more and 70% or less. When the mass percentage is 30% or more, the thermoelectric conversion part 11 can have excellent electrical conductivity. When the mass percentage is 70% or less, the temperature difference in the thermoelectric conversion part 11 tends to be large. The mass percentage may be 35% or more, 40% or more, 45% or more, or 50% or more. The mass percentage may be 65% or less, 60% or less, or 55% or less. The mass percentage of the carbon nanotubes in the total mass of the p-type thermoelectric conversion element 21 may be 30% or more and 70% or less, and the mass percentage of the carbon nanotubes in a total mass of the n-type thermoelectric conversion element 22 may be 30% or more and 70% or less. In each of the plurality of thermoelectric conversion groups 3, the mass percentage of the carbon nanotubes in the total mass of the thermoelectric conversion group 3 may be 30% or more and 70% or less, or 40% or more and 60% or less. The internal temperature difference of the thermoelectric conversion part 11 or the like is measured using, for example, a thermography.

Each of the plurality of conductive parts 4 is a conductive part located on the first main face 2a and is connected to the corresponding thermoelectric conversion group 3. Each conductive part 4 may be a semiconductor instead of a conductor. The thickness of each conductive part 4 is identical or substantially identical to the thickness T1 of the p-type thermoelectric conversion element 21. The conductivity of each conductive part 4 may be equal to or higher than the conductivity of the p-type thermoelectric conversion element 21. The thermal conductivity of each conductive part 4 may be equal to or higher than the thermal conductivity of the p-type thermoelectric conversion element 21. At least a part of the plurality of conductive parts 4 may have a single-layer structure or a laminated structure. For example, at least a part of the plurality of conductive parts 4 may have an organic conductive layer and a metal conductive layer located on the organic conductive layer. In the present embodiment, the plurality of conductive parts 4 are formed of the identical material as the p-type thermoelectric conversion element 21. Therefore, each conductive parts 4 has identical conductivity type (p-type).

The plurality of conductive parts 4 include a first conductive part 4a functioning as a terminal connected to the external device and a second conductive part 4b functioning as a conductive path connecting the adjacent thermoelectric conversion groups 3 to each other. The plurality of conductive parts 4 have two first conductive parts 4a, and the two first conductive parts 4a are located in one conductive region R2. Only the second conductive parts 4b are provided in the other conductive region R2. The plurality of thermoelectric conversion groups 3 are connected in series to each other via a plurality of second conductive parts 4b. Thus, when the thermoelectric conversion module 1 is performing thermoelectric conversion, current can flow in series from one first conductive part 4a to the other first conductive part 4a. For example, one first conductive part 4a located in one conductive region R2 is connected to one end of the first thermoelectric conversion group 3a in the first direction D2, and one second conductive part 4b located in the other conductive region R2 is connected to the other end of the first thermoelectric conversion group 3a and one end of the second thermoelectric conversion group 3b in the first direction D2.

The plurality of thermal conduction parts 5 are portions exhibiting higher thermal conductivity than the substrate 2, and are located on the second main face 2b. At least a part of the plurality of thermal conduction parts 5 overlaps the thermoelectric conversion group 3 (that is, the thermoelectric conversion part 11) in the thickness direction D1. More specifically, at least a part of the plurality of thermal conduction parts 5 overlaps an end of the thermoelectric conversion part 11. On the other hand, each thermal conduction part 5 does not overlap the center of the thermoelectric conversion part 11. Accordingly, a temperature gradient inside the thermoelectric conversion part 11 along the first direction D2 can be favorably generated. The plurality of thermal conduction parts 5 are spaced apart from each other along the first direction D2, and have a band shape extending along the second direction in a plan view. The shape of each thermal conduction part 5 in a plan view is not particularly limited, and is, for example, a polygonal shape, a circular shape, an elliptical shape or the like. Each thermal conduction part 5 includes, for example, metal (silver, copper or the like), carbon, resin (for example, silicone resin, epoxy-based resin, (meth) acrylic-based resin) or the like. Each thermal conduction part 5 may include a ceramic such as boron nitride, aluminum nitride or the like that exhibits high thermal conductivity. From the viewpoint of manufacturing efficiency, each thermal conduction part 5 may include the resin described above. In this case, the thermal conduction part 5 may be formed using the resin or a solution containing the resin.

The thermal conductivity of each thermal conduction part 5 is, for example, 1 W/mK or more and 400 W/mK or less. Accordingly, when the thermoelectric conversion module 1 is heated, heat is favorably transferred to the thermoelectric conversion part 11 via the plurality of thermal conduction parts 5. The thermal conductivity may be, for example, 2.0 W/mK or more, 3.0 W/mK or more, 5.0 W/mK or more, or 10.0 W/mK or more. In the present embodiment, the thermal conductivity of each thermal conduction part 5 is 2.0 W/mK or more and 5.0 W/mK or less, but is not limited thereto. The thermal conductivity of each thermal conduction part 5 is measured by a steady state method or a non-steady state method. The linear expansion coefficient of each thermal conduction part 5 in the in-plane direction is, for example, 100 ppm/K or more and 200 ppm/K or less. The linear expansion coefficient of each thermal conduction part 5 is measured by thermal mechanical analysis (TMA), for example.

The length T2 of each thermal conduction part 5 along the thickness direction D1 is, for example, 50 µm or more and 2,000 µm or less. The width L2 of each thermal conduction part 5 along the first direction D2 is, for example, 0.5 mm or more and 2.0 mm or less. In these cases, the thermal conduction function of each thermal conduction part 5 can be favorably exhibited. In two adjacent thermal conduction parts 5, the interval S along the first direction D2 is greater than the length L1 of the p-type thermoelectric conversion element 21 in the first direction D2 and the length of the n-type thermoelectric conversion element 22 in the first direction D2, and is 3 mm or more and 15 mm or less. The interval S may be greater than or equal to 4 mm, greater than or equal to 5 mm, greater than or equal to 6 mm, less than or equal to 12 mm, less than or equal to 10 mm, or less than or equal to 8 mm. Alternatively, the interval S may be less than 12 mm or less than 10 mm.

Hereinafter, one thermal conduction part 5 of the two thermal conduction parts 5 illustrated in (b) of FIG. 2 may be referred to as a first thermal conduction part 5a, and the other thermal conduction part 5 adjacent to the first thermal conduction part 5a along the first direction D2 may be referred to as a second thermal conduction part 5b. In this case, in the thickness direction D1, the first thermal conduction part 5a overlaps one end of the first thermoelectric conversion part 11a in the first direction D2. Further, in the thickness direction D1, the second thermal conduction part 5b overlaps the other end of the first thermoelectric conversion part 11a in the first direction D2. More specifically, in the thickness direction D1, the first thermal conduction part 5a overlaps the second end part 22b of the n-type thermoelectric conversion element 22 included in the first thermoelectric conversion part 11a, and the second thermal conduction part 5b overlaps the second end part 21b of the p-type thermoelectric conversion element 21 included in the first thermoelectric conversion part 11a. In addition, as shown in (a) of FIG. 2, in the thickness direction D1, the first thermal conduction part 5a overlaps the second end part 21b of the p-type thermoelectric conversion element 21 included in the second thermoelectric conversion part 11b, and the second thermal conduction part 5b overlaps the second end part 22b of the n-type thermoelectric conversion element 22 included in the second thermoelectric conversion part 11b.

The plurality of thermal insulating members 6 are portions exhibiting lower or equal to thermal conductivity than that of the substrate 2, and are located on the second main face 2b. Each of the plurality of thermal insulating members 6 is located between the corresponding first thermal conduction part 5a and second thermal conduction part 5b. The plurality of thermal insulating members 6 are spaced apart from each other along the first direction D2. The shape of each thermal insulating member 6 in a plan view is not particularly limited, and is, for example, a polygonal shape, a circular shape, an elliptical shape or the like. In the present embodiment, each thermal insulating member 6 has a band shape extending along the second direction in a plan view and is in contact with both the corresponding first thermal conduction part 5a and second thermal conduction part 5b. Therefore, the width of each thermal insulating member 6 along the first direction D2 in the present embodiment corresponds to the interval S. The length T3 of each thermal insulating member 6 along the thickness direction D1 is smaller than the length T2 of each thermal conduction part 5. For example, the length T3 is 80% or less, or 70% or less of the length T2. In this case, the thermal insulating member 6 is less likely to peel off from the substrate 2 when the thermoelectric conversion module 1 is deformed.

At least a part of each of the plurality of thermal insulating members 6 overlaps the center of the corresponding thermoelectric conversion part 11 in the thickness direction D1. In other words, in each thermoelectric conversion part 11, the first end part 21a of the p-type thermoelectric conversion element 21 and the first end part 22a of the n-type thermoelectric conversion element 22 overlap at least a part of each of the plurality of thermal insulating members 6 in the thickness direction D1. Accordingly, the temperature at the center part of each thermoelectric conversion part 11 can be stabilized, so that a temperature gradient inside the thermoelectric conversion part 11 along the first direction D2 tends to be stably generated. Therefore, the variation range of the temperature difference inside each thermoelectric conversion part 11 during a predetermined period can be, for example, 2.5°C or less, 2.0°C or less, or 1.0°C or less. The variation range of the temperature difference of the thermoelectric conversion part 11 is obtained by measuring the temporal change of each of the high-temperature region (for example, both end parts of the thermoelectric conversion part 11 in the first direction D2) and the low-temperature region (for example, the center of the thermoelectric conversion part 11 in the first direction D2) of the thermoelectric conversion part 11. The predetermined period is not particularly limited, but is, for example, 10 seconds or more and 100 hours or less.

Each thermal insulating member 6 includes, for example, cellulose nanofiber (CNF), silica aerogel, resin (for example, silicone) or the like. Each thermal insulating member 6 may be a foam. The thermal conductivity of each thermal insulating member 6 is, for example, 0.01 W/mK or more and 0.1 W/mK or less. The thermal conductivity may be 0.02 W/mK or more, 0.03 W/mK or more, 0.08 W/mK or less, or 0.05 W/mK or less. In the present embodiment, the thermal conductivity of each thermal insulating member 6 is, for example, 0.02 W/mK or more and 0.05 W/mK or less, but is not limited thereto. The linear expansion coefficient of each thermal insulating member 6 is, for example, 200 ppm/K or less. The linear expansion coefficient of each thermal insulating member 6 is measured by, for example, thermos mechanical analysis (TMA). The difference in linear expansion coefficient between each thermal conduction part 5 and each thermal insulating member 6 is, for example, 100 ppm/K or less. Accordingly, even in the case the thermoelectric conversion module 1 is deformed to mount on the heat source, the thermoelectric conversion module 1 can maintain the stable temperature gradient to generate power without peeling off from the heat source. The difference may be 80 ppm/K or less, 50 ppm/K or less, or 10 ppm/K or less.

The thermoelectric conversion module 1 may further include configurations other than those described above. For example, the thermoelectric conversion module 1 may include wiring for electrically connecting another thermoelectric conversion module, wiring for taking out power to an external circuit, and the like.

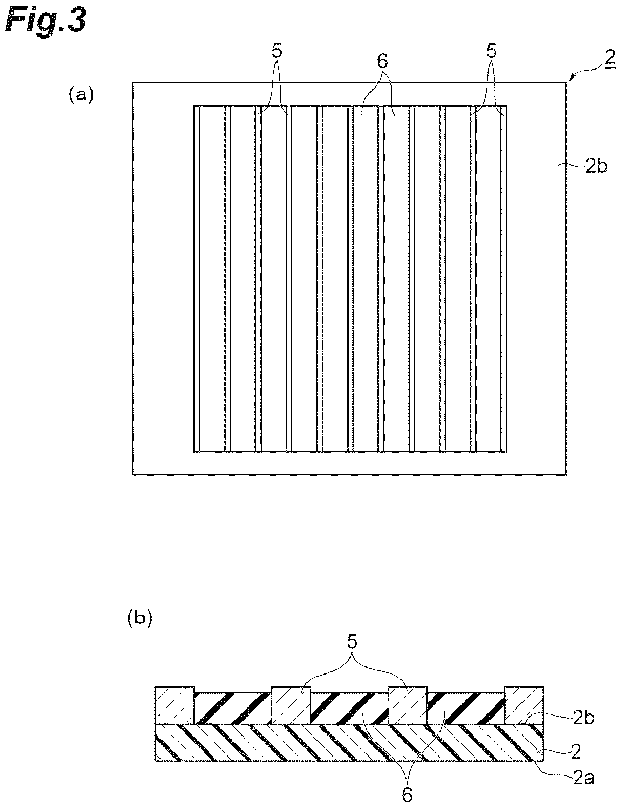

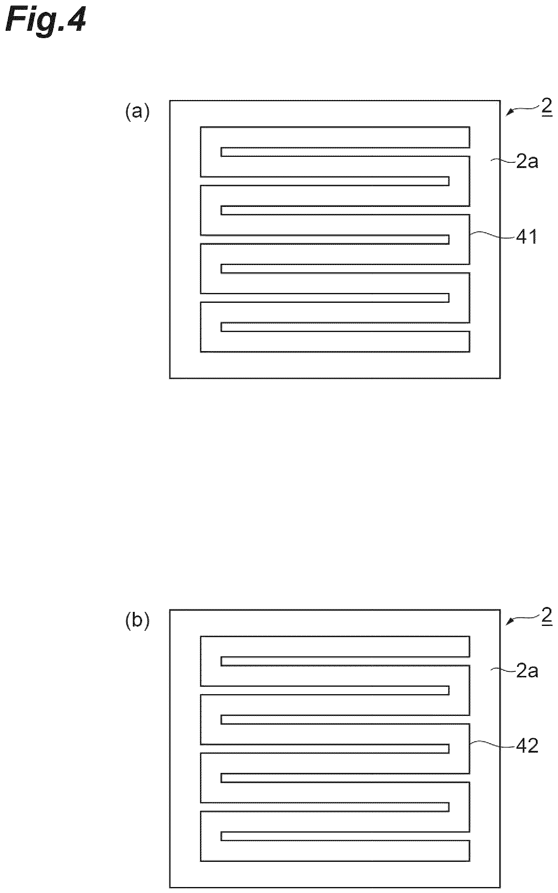

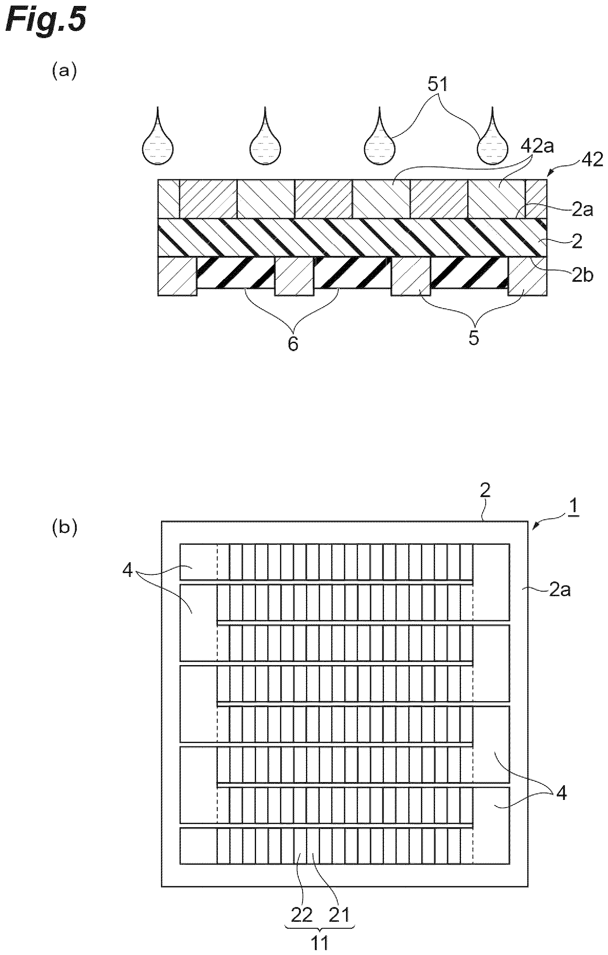

Next, an example of a method for manufacturing the thermoelectric conversion module 1 according to the present embodiment will be described with reference to FIGS. 3 to 5. (a) and (b) of FIG. 3, (a) and (b) of FIG. 4, and (a) and (b) of FIG. 5 illustrate a method for manufacturing a thermoelectric conversion module according to the present embodiment.

First, as shown in (a) and (b) of FIG. 3, the plurality of thermal conduction parts 5 and the plurality of thermal insulating members 6 are formed on a second main face 2b (one main face) of the substrate 2 prepared in advance (first step). In the first step, a high thermal conduction material and a thermal insulating material are coated on the second main face 2b by a known method such as an inkjet method, a dispensing method, a doctor-blade method or a screen printing method. The high thermal conduction material and the thermal insulating material may be coated simultaneously or at the different timing. Subsequently, the high thermal conduction material and the thermal insulating material are cured by heating, so that the plurality of thermal conduction parts 5 and the plurality of thermal insulating members 6 are formed on the second main face 2b.

Next, as shown in (a) of FIG. 4, a first layer 41 is formed on the first main face 2a (the other main face) (second step). In the second step, first, a dispersion liquid is dropped onto the first main face 2a by a known method such as an inkjet method, a dispensing method, a doctor-blade method, a screen printing method, a casting method, a dip coating method, or a spray coating method. Subsequently, the first layer 41 is formed by drying the dispersion liquid. For example, the substrate 2 is heated by placing the substrate 2 in a blow drying oven set at 25°C or more and 90°C or less for 10 minutes or more and 21,600 minutes or less. Thereby, the dispersion liquid is dried to form the first layer 41.

The dispersion liquid used in the second step is, for example, a liquid in which the p-type thermoelectric conversion material is dispersed. In the present embodiment, the dispersion liquid is a liquid in which the carbon nanotube and the conductive resin are dispersed. The content of the carbon nanotubes in the dispersion liquid is, for example, 25% by mass or more, 30% by mass or more, 35% by mass or more or 40% by mass or more and 80% by mass or less, 75% by mass or less, 70% by mass or less or 60% by mass or less, based on the total amount of the conductive resin and the carbon nanotubes. In this case, the temperature difference is likely to occur in the first layer 41, and the electrical conductivity of the first layer 41 tends to increase. In addition, in each of the plurality of thermoelectric conversion parts 11 described later, a mass percentage of the carbon nanotubes in the total mass of the thermoelectric conversion part 11 is easily adjusted to 30% or more and 70% or less. The total mass concentration of the carbon nanotubes and the conductive resin in the dispersion liquid is, for example, 0.05% by mass or more, 0.06% by mass or more, 0.07% by mass or more, 0.10% by mass or more, 0.12% by mass or more or 0.15% by mass or more. The total mass concentration of the carbon nanotubes and the conductive resin in the dispersion may be 10% by mass or less, or 2% by mass or less. The dispersion liquid used in the second step is, for example, a mixed liquid formed by mixing a first liquid containing a carbon nanotube and a second liquid containing a conductive resin. The content of the carbon nanotubes in the dispersion liquid based on the total amount of the conductive resin and the carbon nanotubes is substantially equal to the mass percentage of the carbon nanotubes in the total mass of the thermoelectric conversion part 11. Therefore, in the present specification, the content of the carbon nanotubes in the dispersion liquid based on the total amount of the conductive resin and the carbon nanotubes can be regarded as the mass percentage of the carbon nanotubes in the total mass of the thermoelectric conversion part 11.

The first liquid includes, for example, the carbon nanotube and a first solvent. The concentration of the carbon nanotubes in the first solvent is, for example, 0.01% by mass or more and 10% by mass or less. The first solvent may be any solvent capable of dispersing the carbon nanotube, and is, for example, a polar liquid or an aqueous solvent. The aqueous solvent is water or a mixed solvent of water and an organic solvent. The first solvent may be a protic solvent or an aprotic solvent. Specific examples of the first solvent include water, alcohols (such as methanol and ethanol), amides (such as N, N-dimethylformamide, N, N-dimethylacetamide and N-methylpyrrolidone), ketones (such as acetone and methyl ethyl ketone), glycols (such as ethylene glycol and diethylene glycol), dimethyl sulfoxide, acetonitrile or the like. In the above-described examples, one or more of the group consisting of water, methanol, ethanol, N-methylpyrrolidone and dimethyl sulfoxide is preferable, and water is more preferable. The first liquid may further include additives such as a surfactant and an organic binder.

The second liquid includes, for example, a conductive resin made of PEDOT and PSS (PEDOT/PSS) and a second solvent. In the PEDOT/PSS, the content ratio of PEDOT and PSS is not particularly limited. The ratio (mass ratio) of PSS to PEDOT is, for example, 1 or more, 1.25 or more, or 1.5 or more and 30 or less, or 20 or less. The second solvent may be any solvent capable of dispersing PEDOT/PSS, and is, for example, a polar liquid or an aqueous solvent. The second solvent may be a protic solvent or an aprotic solvent. Specific examples of the second solvent are identical to the specific examples of the first solvent. In the above-described examples, one or more of the group consisting of water, methanol and ethanol is preferable, and water is more preferable. In one embodiment, the second liquid may be an aqueous dispersion liquid of PEDOT/PSS. The second solvent may be used alone or as a mixture of two or more. The second liquid may further include various additives.

Next, as shown in (b) of FIG. 4, the substrate 2 is immersed in an organic solvent to form a p-type thermoelectric conversion layer 42 (third step). In the present embodiment, after the second step, the first main face 2a of the substrate 2 is immersed in dimethylsulfoxide (DMSO) of the above-described organic solvent (immersion treatment). For example, the first main face 2a of the substrate 2 is immersed in dimethylsulfoxide set at room temperature for 1 minute or more and 7,200 minutes or less. After the immersion treatment, the substrate 2 may be heated in the blow drying oven. For example, the substrate 2 is heated by placing the substrate 2 in the blow drying oven set at 25°C or more and 90°C or less for 10 minutes or more and 21,600 minutes or less. Through the above process, the patterned p-type thermoelectric conversion layer 42 is formed. A part of the p-type thermoelectric conversion layer 42 is to be the n-type thermoelectric conversion element 22 later. Another part of the p-type thermoelectric conversion layer 42 is to be the p-type thermoelectric conversion element 21 later. Still another part of the p-type thermoelectric conversion layer 42 is to be the conductive part 4 later.

Next, as shown in (a) of FIG. 5, after the third step, a dopant-containing solution (dopant solution 51) is dropped onto a part 42a of the p-type thermoelectric conversion layer 42, so that, the p-type thermoelectric conversion element 21 is formed and the n-type thermoelectric conversion element 22 is formed in the part 42a (fourth step). In the fourth step, the part 42a of the p-type thermoelectric conversion layer 42 is impregnated with the dopant solution 51 by a known method such as an inkjet method or a dispensing method. In the present embodiment, in the p-type thermoelectric conversion layer 42, regions where the dopant solution 51 is dropped and regions where the dopant solution 51 is not dropped are alternately provided. Subsequently, the dopant solution 51 is dried so that the part 42a becomes the n-type thermoelectric conversion element 22. For example, the substrate 2 is heated by placing the substrate 2 on a hotplate set at 25°C or more and 90°C or less for 10 minutes or more and 21,600 minutes or less. Thus, the dopant solution 51 is dried. The menstruum contained in the dopant solution 51 is, for example, water, acetonitrile, ethanol, ethylene glycol, dimethyl sulfoxide (DMSO), N-methylpyrrolidone, N, N-dimethylformamide, N, N-dimethylacetamide or the like. A part of the p-type thermoelectric conversion layer 42 to which the dopant solution 51 is not dropped becomes the p-type thermoelectric conversion element 21 or the conductive part 4 as illustrated in (b) of FIG. 5. As described above, the thermoelectric conversion module 1 in which the plurality of thermoelectric conversion parts 11 are formed is formed.

Next, operations and effects achieved by the thermoelectric conversion module 1 formed by the manufacturing method according to the present embodiment described above will be described.

The thermoelectric conversion module 1 according to the present embodiment includes the first thermal conduction part 5a and the second thermal conduction part 5b located on the second main face 2b, in the thickness direction D1, the first thermal conduction part 5a overlaps the second end part 22b of the n-type thermoelectric conversion element 22 included in the first thermoelectric conversion part 11a, and in the thickness direction D1, the second thermal conduction part 5b overlaps the second end part 21b of the p-type thermoelectric conversion element 21 included in the first thermoelectric conversion part 11a. In addition, the thermal insulating member 6 located between the first thermal conduction part 5a and the second thermal conduction part 5b is provided on the second main face 2b. Accordingly, each of the first thermal conduction part 5a and the second thermal conduction part 5b overlaps both ends of the first thermoelectric conversion part 11a in the thickness direction D1, whereas does not overlap the center of the first thermoelectric conversion part 11a. Therefore, for example, by heating the first thermal conduction part 5a and the second thermal conduction part 5b, an internal temperature difference can be generated favorably in each of the p-type thermoelectric conversion element 21 and the n-type thermoelectric conversion element 22. Herein, the thickness T1 of the p-type thermoelectric conversion element 21 (and the thickness of the n-type thermoelectric conversion element 22) is 3 µm or more and 30 µm or less. Since the thickness T1 is within the above ranges, it is possible to suppress an increase in the number of elements per unit area and an internal resistance of the element. In addition, at least a part of the thermal insulating member 6 is overlapped with the center of the thermoelectric conversion part 11 in the thickness direction D1. Thus, at the time of heating, the temperature of the center part of the thermoelectric conversion part 11 where it is relatively low temperature can be stable. Thus, the variation in the temperature difference is less likely to occur inside the thermoelectric conversion part 11. Additionally, each difference in linear expansion coefficient between the first thermal conduction part 5a and the thermal insulating member 6 and between the second thermal conduction part 5b and the thermal insulating member 6 is 100 ppm/K or less. Accordingly, even in the case the thermoelectric conversion part 11 is deformed to mount on the heat source, the thermoelectric conversion module 1 can maintain the stable temperature gradient to generate power without peeling off from the heat source. Therefore, by adopting the thermoelectric conversion module 1 according to the present embodiment, it is possible to realize an output improvement per unit area and stable output regardless of the temperature of the heat source.

In the present embodiment, each linear expansion coefficient of the first thermal conduction part 5a and the second thermal conduction part 5b may be 100 ppm/K or more and 200 ppm/K or less, and the linear expansion coefficient of the thermal insulating member 6 may be 200 ppm/K or less. In this case, even in the case the thermoelectric conversion module 1 is deformed to mount on the heat source, the thermoelectric conversion module 1 can maintain the stable temperature gradient to generate power without peeling off from the heat source.

In the present embodiment, the width L2 of each thermal conduction part 5 along the first direction D2 may be 0.5 mm or more and 1.5 mm or less. In this case, the heat transfer performance by each thermal conduction part 5 is favorably exhibited, and the internal temperature difference of the thermoelectric conversion part 11 can be increased.

In the present embodiment, each thermal conductivity of the first thermal conduction part 5a and the second thermal conduction part 5b may be 2.0 W/mK or more and 5.0 W/mK or less, and the thermal conductivity of the thermal insulating member 6 may be 0.01 W/mK or more and 0.05 W/mK or less. In this case, the internal temperature difference of the thermoelectric conversion part 11 can be generated more favorably.

In the present embodiment, the thickness T1 of the p-type thermoelectric conversion element 21 may be 5 µm or more and 25 µm or less. The interval S may be 3 mm or more and less than 12 mm. In these cases, it is possible to realize further output improvement per unit area of the thermoelectric conversion module 1.

In the present embodiment, each of the substrate 2, the thermoelectric conversion part 11, the thermal conduction part 5 and the thermal insulating member 6 may have a flexibility. In this case, for example, the thermoelectric conversion module 1 can be easily provided along the surface of the cylindrical pipe. That is, it is possible to relax the restriction on the mounting place of the thermoelectric conversion module 1.

In the present embodiment, the dopant solution 51 is dropped onto the part 42a of the p-type thermoelectric conversion layer 42 to make the part 42a become the n-type thermoelectric conversion element 22. In this case, the contact resistance between the p-type thermoelectric conversion element 21 and the n-type thermoelectric conversion element 22 can be favorably reduced. Dropping of the dopant solution 51 is performed after formation of the thermal conduction part 5. Thus, the material contained in the dopant solution 51 is less likely to be deteriorated by heating or the like.

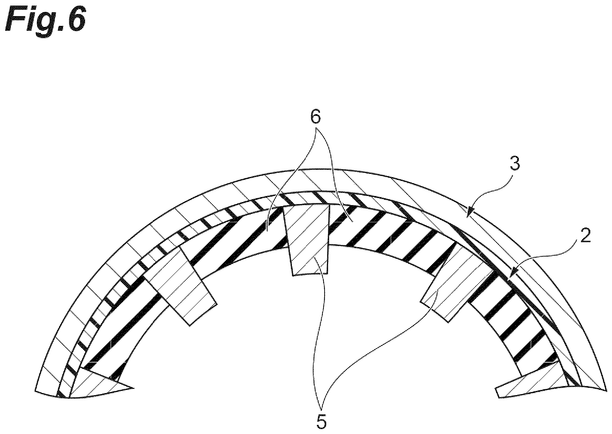

In the present embodiment, the length T3 of each thermal insulating member 6 along the thickness direction D1 is smaller than the length T2 of each thermal conduction part 5, for example, the length T3 is 80% or less or 70% or less of the length T2. In this case, as shown in FIG. 6, each thermal insulating member 6 is less likely to hinder the deformation of the substrate 2. This makes it less likely that excessive compressive stress or the like is applied to the boundary between the thermal conduction part 5 and the thermal insulating member 6, making it less likely that the thermal insulating member 6 peels off from the substrate 2 during deformation of the thermoelectric conversion module 1.

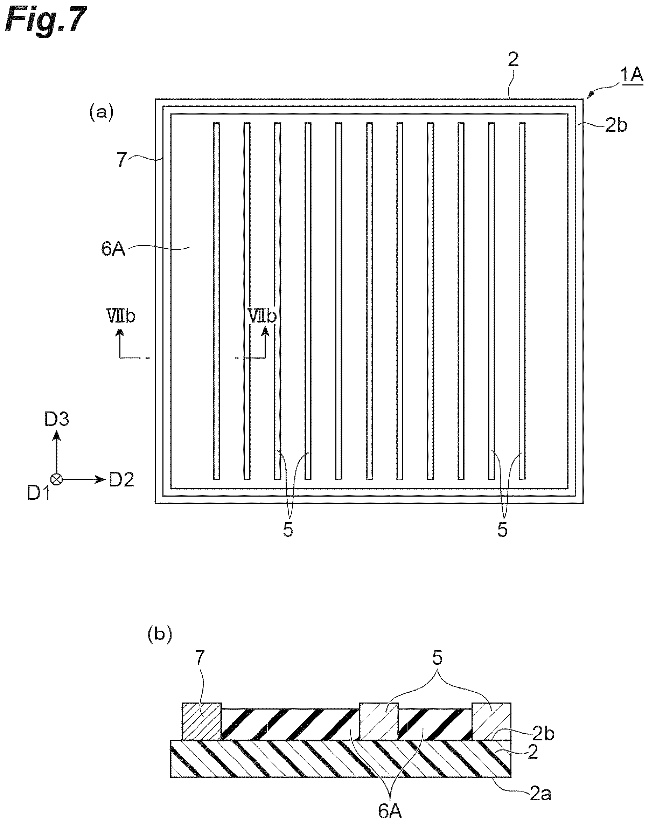

The thermoelectric conversion module and the manufacturing method thereof according to the present disclosure are not limited to the above-described embodiment and modification, various other modifications are possible.
(a) of FIG. 7 is a schematic bottom view illustrating a thermoelectric conversion module according to the modification. (b) of FIG. 7 is a schematic cross-sectional view taken along line VIIb-VIIb of (a) of FIG. 7. In (b) of FIG. 7, the configuration provided on the first main face 2a is omitted. The thermoelectric conversion module 1A shown in (a) and (b) of FIG. 7 is different from the thermoelectric conversion module 1 of the above-described embodiment in that it further includes a heat dissipation member 7 located on the second main face 2b. In addition, the shape of the thermal insulating member 6A included in the thermoelectric conversion module 1A is different from the shape of the thermal insulating member 6 of the above-described embodiment. The heat dissipation member 7 is a member for dissipating heat accumulated in the thermoelectric conversion module 1A and has a frame shape surrounding each thermal conduction part 5 and the thermal insulating member 6A in a plan view. In this modification, the heat dissipation member 7 has a rectangular frame shape, but it is not limited thereto. The thermal insulating member 6A is provided to fill the region surrounded by the heat dissipation member 7. Therefore, the thermal insulating member 6A is in contact with not only each thermal conduction part 5 but also the heat dissipation member 7, and each thermal conduction part 5 is surrounded by the thermal insulating member 6A in a plan view.

The thermal conductivity of the heat dissipation member 7 is at least higher than the thermal conductivity of the substrate 2, and is, for example, 1 W/mK or more and 400 W/mK or less. The thermal conductivity of the heat dissipation member 7 is measured by a steady state method or a non-steady state method. The difference in the linear expansion coefficient between the heat dissipation member 7 in the in-plane direction and the thermal insulating member 6 is, for example, 100 ppm/K or less. This allows the thermoelectric conversion module 1A to maintain the stable temperature gradient to generate power without peeling off from the heat source, even in the case the thermoelectric conversion module 1A is deformed to mount on the heat source. The same operations and effects as those of the above-described embodiment can be achieved in this modification. Additionally, since the heat dissipation member 7 is provided, it becomes less likely for heat to accumulate in the thermoelectric conversion module 1A, making it easier to maintain the temperature difference within the thermoelectric conversion part 11.

Although the thermoelectric conversion element is exposed on the first main face in the above-described embodiment and modification, the present disclosure is not limited thereto. For example, the thermoelectric conversion element may be covered with a resinous sealing layer or the like. In addition, an insulator may be provided between two adjacent thermoelectric conversion groups. In this case, from the viewpoint of maintaining the internal temperature difference of the thermoelectric conversion part, the thermal conductivity of the insulator is preferably low.

In the above-described embodiment and modification, the thermal insulating member is formed by drying a thermal insulating material coating on the substrate, but is not limited thereto. For example, the thermal insulating member formed in advance may be fixed on the substrate.

### Examples

One aspect of the present disclosure will be described in more detail with the following examples, but one aspect of the present disclosure is not limited to these examples.

### (Example 1)

### <Thermal insulating member>

A thermal insulation material sheet ("Finesulight" (registered trademark) standard type, manufactured by Sumitomo Riko Company Limited, thickness: 0.63 mm) was cut to a width of 10 mm and a length of 96 mm to use as a thermal insulating member.

### <Dispersion liquid>

80 g of carbon nanotube dispersion liquid (concentration: 0.2% by mass, G/D ratio: 41, aqueous dispersion liquid, single-walled carbon nanotubes, diameters: 0.9 to 1.7 nm, thermal conductivity: 30 W/mK) was concentrated by evacuation until the carbon nanotube concentration became 0.4% by mass. Subsequently, 5.7g of PEDOT/PSS aqueous dispersion liquid ("Clevious PH1000" manufactured by Heraeus Holding, solid content concentration: 1.2% by mass) and the concentrated carbon nanotube dispersion liquid were sufficiently stirred with a three one motor ("PM203 type" manufactured by AS ONE CORPORATION) (stirring time: 30 minutes). Thus, a dispersion liquid in which the content of the carbon nanotubes was 75% by mass with respect to the total amount of the PEDOT/PSS and the carbon nanotubes was prepared. The viscosity of the dispersion liquid at a shear rate of 0.01s⁻¹ was 1,320,000 mPa·sec. The viscosity of the dispersion liquid was measured using a rheometer ("MCR302" (product name) manufactured by Anton Paar GmbH). The measurement conditions were as follows: 25°C of temperature, ϕ 25 mm parallel plate of plate, 1 mm of gap.

### <Dopant solution>

0.32 g of potassium ferrocyanide trihydrate and 0.94 g of benzo-18-crown-6-ether were dissolved in 15 mL of ultrapure water to obtain a dopant solution. The concentrations of potassium ions and benzo-18-crown-6-ether in the dopant solution were 0.2 M, respectively. A molar ratio (C₂/C₁) was 1.

### <Substrate>

A 100mm square polyimide film (manufactured by DU PONT-TORAY Co., Ltd., Kapton H type, film thickness of 25 µm, and thermal conductivity of 0.16 W/mK) was prepared as a substrate material. The polyimide film was washed with acetone.

### <Thermoelectric conversion module>

A spray adhesive ("Regular Series S/N 55" manufactured by 3M Japan Limited) was applied to one side of the thermal insulating member, and the thermal insulating member was attached to the polyimide film with a gap of 1.0 mm. Subsequently, the gap was coated with a high thermal conduction material (manufactured by Shin-Etsu Chemical Co., Ltd., G-789) using a dispenser "AD3000C" and a desktop robot "EzROBO-5GX" manufactured by Iwashita Engineering, Inc. At this time, an interval of the nozzle position along a first direction from which the high thermal conduction material was discharged was set to 11 mm, and the coating was performed by moving the nozzle along a second direction orthogonal to the first direction. As a result, a plurality of high thermal conduction materials having band shapes were coated on the second main face. After coating, the substrate was placed on a hotplate set at 120°C for 60 minutes. Thus, a plurality of thermal conduction parts was formed. Each of the thickness and the width of the thermal conduction part was 1 mm, and the interval between the thermal conduction parts in the first direction was 10 mm. The thermal insulating member was arranged and fixed to fill the interval of 10 mm.

The dispersion liquid was coated on the first main face of the polyimide film using a jet dispenser "AeroJetR" and a desktop robot "SHOTMASTER400ΩX" manufactured by Musashi Engineering, Inc. Subsequently, the laminated body coated with the dispersion liquid was housed in a blow drying oven set at 60°C for 3 hours. In this manner, a composite film having a thickness of 62 µm was formed on the polyimide film. Both a thermoelectric conversion region and a conductive part of the composite film were provided on the polyimide film. The direction in which the thermoelectric conversion region extends is orthogonal to the direction in which the thermal conduction parts and the thermal insulating member extend.

The thickness of the composite film was measured using a high-accuracy digital micrometer (manufactured by Mitutoyo Corporation, MDH-25MB). Specifically, the thickness of the part where the composite film was provided and the thickness of the part where the composite film was not provided (the part where only the polyimide film was provided) were measured respectively, and the difference between the two was taken as the thickness of the composite film.

Next, the first main face on the polyimide film was immersed in DMSO (manufactured by FUJIFILM Wako Pure Chemical Corporation) at room temperature for 30 minutes. Subsequently, the polyimide film took up from the DMSO was placed on a hot plate set at 60°C for 120 minutes. In this manner, the p-type thermoelectric conversion layer was formed on the first main face of the polyimide film. In Example 1, the thickness of the p-type thermoelectric conversion layer was 14.7 µm.

Next, the dopant solution was dropped onto a part of the p-type thermoelectric conversion layer functioning as a thermoelectric conversion element using an inkjet printer "Material Printer DMP2850" manufactured by FUJIFILM Corporation. In Example 1, first, the dopant solution was dropped onto the area with the width of 10 mm and the length of 5.5 mm. Subsequently, the dopant solution was dropped onto the area with the width of 10 mm and the length of 5.5 mm in the same way after leaving a space with the length of 5.5 mm. By repeating this dropping operation, the region to which the dopant solution was dropped and the region to which the dopant solution was not dropped were alternately arranged. Through above process, 48 p-type thermoelectric conversion elements and 48 n-type thermoelectric conversion elements were formed on the polyimide film. That is, a total of 96 thermoelectric conversion elements were formed on the polyimide film. Accordingly, a total of 48 thermoelectric conversion parts, each of that including one p-type thermoelectric conversion element and one n-type thermoelectric conversion element, are formed. Herein, the thickness of the n-type thermoelectric conversion element was substantially identical to the thickness of the p-type thermoelectric conversion element. End parts of each thermoelectric conversion part overlap the thermal conduction part, and at least a center of each thermoelectric conversion part does not overlap the thermal conduction part. The area occupied by the thermoelectric conversion elements on the polyimide film was 52.8 cm². The area occupied by two conductive regions R2 on the polyimide film was 17.4 cm². The mass percentage of the carbon nanotubes in the total mass of the thermoelectric conversion part is 30% or more and 70% or less. The content of the iron atom in the n-type thermoelectric conversion element was 0.01% by mass or more and 10% by mass or less.

Next, the polyimide film on which above-described thermoelectric conversion elements are provided was left on a hotplate to dry for 30 minutes. Subsequently, the polyimide film was housed in a blow drying oven set at 100°C for 60 minutes. Through above processes, a thermoelectric conversion module in which the p-type thermoelectric conversion element and the n-type thermoelectric conversion element were alternately arranged in series connection was manufactured. The thermal conductivity of the p-type thermoelectric conversion element in the in-plane direction was 32 W/mK. Each parameter of the thermoelectric conversion module according to Example 1 is shown in Table 1 below.

### (Comparative Example 1)

A thermoelectric conversion module was formed in the same manner as in Example 1, except that the thermal insulating member was not provided on the second main face of the substrate. Therefore, a space was provided between the two adjacent thermal conduction parts. Each parameter of the thermoelectric conversion module according to Comparative Example 1 is shown in Table 1 below. The thermal conductivity of the space (air) was set to 0.02 W/mK.

### (Comparative Example 2)

A thermoelectric conversion module was formed in the same manner as in Example 1, except that a foamed silicone ("KE-521" manufactured by Shin-Etsu Chemical Co., Ltd.) was used as the thermal insulating member. Each parameter of the thermoelectric conversion module according to Comparative Example 2 is shown in Table 1 below.

### (Comparative Example 3)

A thermoelectric conversion module was formed in the same manner as in Example 1, except that the thermal conduction parts were made of aluminum square bars. Each parameter of the thermoelectric conversion module according to Comparative Example 3 is shown in Table 1 below.

### (Method for Measuring Linear Expansion Coefficient)

A test piece made of the same material as the thermal conduction parts of Example 1, having a size of 3 cm square and a thickness of 1 mm, was prepared. Next, the test piece was sandwiched between anti-adhesion plates with a thickness of 2 mm, placed on a quartz standard sample with a thickness of 10 mm, and the linear expansion coefficient in the in-plane direction of the test piece was measured using a thermal mechanical analyzer "TMA-4000SA" manufactured by Bruker Japan K.K. In addition, test pieces made of the same material as the thermal conduction parts of Comparative Example 3, made of the same material as the thermal insulating member of Example 1, and made of the same material as the thermal insulating member of Comparative Example 2 were prepared, and the linear expansion coefficients in the in-plane direction of each test piece were measured. The measurement results of the linear expansion coefficients of each test piece are shown in Table 1 below.

**[Table 1]**

| | unit | Example 1 | Comparative Example 1 | Comparative Example 2 | Comparative Example 3 |
|---|---|---|---|---|---|
| interval between the thermal conduction parts | mm | 10 | 10 | 10 | 10 |
| linear expansion coefficient of the thermal conduction part | ppm/K | 140 | 140 | 140 | 23 |
| thermal conductivity of the thermal conduction part | W/mK | 3.0 | 3.0 | 3.0 | 204 |
| sensation between thermal insulating members | mm | 1.0 | 1.0 | 1.0 | 1.0 |
| linear expansion coefficient of the thermal insulating member | ppm/K | 136 | - | 500 | 136 |
| thermal conductivity of the thermal insulating member | W/mK | 0.03 | 0.02 | 0.06 | 0.03 |
| length of the thermoelectric conversion element | mm | 5.5 | 5.5 | 5.5 | 5.5 |
| thickness of the thermoelectric conversion element | µm | 11.1 | 11.1 | 11.1 | 11.1 |
| the number of the thermoelectric conversion elements | - | 96 | 96 | 96 | 96 |
| the area of the thermoelectric conversion element | cm² | 52.8 | 52.8 | 52.8 | 52.8 |

### (Power Generation Evaluation of Thermoelectric Conversion Module)

The thermal conduction parts of the thermoelectric conversion modules of Examples 1 and Comparative Examples 1 to 3 were brought into contact with and wound around SUS pipes with a diameter of 76 mm heated to 100°C by a silicone rubber heater. Thus, a temperature difference was caused in each thermoelectric conversion element to set the thermoelectric conversion module in generating power state (hereinafter simply referred to as "power generation state"). In each thermoelectric conversion module, resistance value, open-circuit voltage, short-circuit current, maximum output and maximum output density per unit area of the thermoelectric conversion element were evaluated using a source meter ("Keithley 2612B" manufactured by Tektronix Inc.). The temperature difference in the thermoelectric conversion part was measured by a thermography ("InfRec R550Pro" manufactured by Nippon Avionics Co., Ltd.). In the case where resistance value, open-circuit voltage, short-circuit current and maximum output are each set to 100 in the thermoelectric conversion module of Comparative Example 1, the evaluating results of Examples 1 and Comparative Examples 1 to 3 are shown in Table 2 below.

In addition, a durability test was conducted to maintain the power generation state in the atmosphere for 100 hours while the thermoelectric conversion modules were wound around the SUS pipes. The thermoelectric conversion modules of Example 1 and Comparative Example 1 were still wound around the SUS pipes without deformation even after 100 hours. On the other hand, the thermoelectric conversion module of Comparative Example 2 peeled off from the SUS pipe before the end of the durability test, but no damage was observed in the thermoelectric conversion elements. In addition, the thermoelectric conversion module of Comparative Example 3 was bent after the durability test, and cracks were observed in some of the thermoelectric conversion elements. From this, it can be said that the thermoelectric conversion modules of Example 1 and Comparative Examples 1 and 2 have flexibility, while the thermoelectric conversion module of Comparative Example 3 does not have flexibility.

After 100 hours, the power generation amount and the temperature difference of Example 1 and Comparative Example 1 were measured using the source meter and thermography. The value obtained by dividing power generation amount and temperature difference after 100 hours by the initial power generation amount and temperature difference, respectively, was defined as the "maintenance rate," and the calculation results are shown in Table 3. In Table 3, each maintenance rate of the power generation amount of Comparative Examples 2 and 3 is set to 0%, and each maintenance rate of the temperature difference is not measurable.

**[Table 2]**

| | Example 1 | Comparative Example 1 | Comparative Example 2 | Comparative Example 3 |
|---|---|---|---|---|
| resistance value (normalization value) | 100 | 100 | 100 | 100 |
| open-circuit voltage (normalization value) | 180 | 100 | 120 | 110 |
| short-circuit current (normalization value) | 180 | 100 | 120 | 110 |
| output (normalization value) | 324 | 100 | 144 | 121 |
| temperature difference (normalization value) | 180 | 100 | 120 | 110 |

**[Table 3]**

| | Example 1 | Comparative Example 1 | Comparative Example 2 | Comparative Example 3 |
|---|---|---|---|---|
| variation range of the temperature difference(°C) | 1.0 | 3.0-7.0 | 1.0-2.0 | 1.0 |
| maintenance rate of power generation amount (%) | 100 | 90 | 0 | 0 |
| maintenance rate of the temperature difference (%) | 100 | 95 | - | - |

As shown in Table 2, the open-circuit voltage of Example 1 was about 1.8 times higher than that of Comparative Example 1. The short-circuit current of Example 1 was also about 1.8 times higher than that of Comparative Example 1. The variation range of the temperature difference in Example 1 was smaller than the variation range of the temperature in Comparative Example 1. Specifically, the variation range of the temperature difference in Example 1 was about 1/7 to 1/3 of that in Comparative Example 1. On the other hand, open-circuit voltages and short-circuit currents of Comparative Examples 2 and 3 were both higher than those of Comparative Example 1. As mentioned above, since the thermoelectric conversion module of Comparative Example 3 does not have flexibility, it cannot be said to be practical as a power source. From the above, it can be seen that Example 1 and Comparative Example 2 are more practical as power sources than Comparative Examples 1 and 3.

The maintenance rate of the power generation amount and the maintenance rate of the temperature difference after the durability test of Example 1 were both 100%, which were higher than those of Comparative Example 1. On the other hand, as mentioned above, the thermoelectric conversion module of Comparative Example 2 peeled off from the SUS pipe before the end of the durability test, and the thermoelectric conversion module of Comparative Example 3 had cracks in some of the thermoelectric conversion elements after the durability test. Therefore, in Comparative Examples 2 and 3, the power generation of the thermoelectric conversion module could not be maintained. From these results, it can be seen that Example 1 is more useful as a thermoelectric conversion module than Comparative Examples 1 to 3.

### Reference Signs List

1,1A; thermoelectric conversion module
2; substrate
2a; first main face
2b; second main face
3; thermoelectric conversion group
3a; first thermoelectric conversion group
3b; second thermoelectric conversion group
4; conductive part
5; thermal conduction part
5a; first thermal conduction part
5b; second thermal conduction part
6,6A; thermal insulating member
7; heat dissipation member
11; thermoelectric conversion part
11a; first thermoelectric conversion part
11b; second thermoelectric conversion part
21; p-type thermoelectric conversion element
21a; first end part
21b; second end part
22; n-type thermoelectric conversion element
22a; first end part
22b; second end part
D1; thickness direction
D2; first direction
D3; second direction
L1; length
L2; width
S; interval
R1; thermoelectric conversion region
R2; conductive region
T1; thickness
T2,T3; length.

## Claims

1. A thermoelectric conversion module comprising:
a substrate having a first main face and a second main face located opposite the first main face;
a thermoelectric conversion part located on the first main face;
a first thermal conduction part and a second thermal conduction part located on the second main face and adjacent to each other along a first direction orthogonal to a thickness direction of the substrate; and
a thermal insulating member located on the second main face and at least between the first thermal conduction part and the second thermal conduction part,
wherein the thermoelectric conversion part comprises a p-type thermoelectric conversion element and an n-type thermoelectric conversion element arranged along the first direction,
wherein a first end part of the p-type thermoelectric conversion element in the first direction is in contact with a first end part of the n-type thermoelectric conversion element in the first direction and overlaps with the thermal insulating member in the thickness direction,
wherein, in the thickness direction, the first thermal conduction part is overlapped with a second end part of the p-type thermoelectric conversion element in the first direction,
wherein, in the thickness direction, the second thermal conduction part is overlapped with a second end part of the n-type thermoelectric conversion element in the first direction,
wherein each thickness of the p-type thermoelectric conversion element and the n-type thermoelectric conversion element is 3 µm or more and 30 µm or less, and
wherein each of a difference in linear expansion coefficient between the first thermal conduction part and the thermal insulating member and a difference in linear expansion coefficient between the second thermal conduction part and the thermal insulating member is 100 ppm/K or less.

2. The thermoelectric conversion module according to claim 1,
wherein each linear expansion coefficient of the first thermal conduction part and the second thermal conduction part is 100 ppm/K or more and 200 ppm/K or less, and
wherein the linear expansion coefficient of the thermal insulating member is 200 ppm/K or less.

3. The thermoelectric conversion module according to claim 1 or 2,
wherein each width of the first thermal conduction part and the second thermal conduction part along the first direction is 0.5 mm or more and 1.5 mm or less.

4. The thermoelectric conversion module according to claim 1 or 2,
wherein each thermal conductivity of the first thermal conduction part and the second thermal conduction part is 2.0 W/mK or more and 5.0 W/mK or less, and
wherein the thermal conductivity of the thermal insulating member is 0.02 W/mK or more and 0.05 W/mK or less.

5. The thermoelectric conversion module according to claim 1 or 2, further comprising a heat dissipation member located on the second main face,
wherein as viewed from the thickness direction, the heat dissipation member surrounds the first thermal conduction part, the second thermal conduction part and the thermal insulating member.

6. The thermoelectric conversion module according to claim 1 or 2,
wherein each thickness of the p-type thermoelectric conversion element and the n-type thermoelectric conversion element is 5 µm or more and 25 µm or less, and
wherein an interval between the first thermal conduction part and the second thermal conduction part in the first direction is 3 mm or more and less than 12 mm.

7. The thermoelectric conversion module according to claim 1 or 2, further comprising:
a first thermoelectric conversion group located on the first main face and having the thermoelectric conversion part; and
a second thermoelectric conversion group located on the first main face and adjacent to the first thermoelectric conversion group along a second direction orthogonal to the thickness direction and the first direction,
wherein the second thermoelectric conversion group has a second thermoelectric conversion part adjacent to a first thermoelectric conversion part along the second direction,
wherein the second thermoelectric conversion part has a second p-type thermoelectric conversion element and a second n-type thermoelectric conversion element arranged along the first direction,
wherein a first end part of the second p-type thermoelectric conversion element in the first direction is in contact with a first end part of the second n-type thermoelectric conversion element in the first direction and overlaps with the thermal insulating member in the thickness direction,
wherein the first thermal conduction part and the second thermal conduction part each extend along the second direction,
wherein, in the thickness direction, the first thermal conduction part is overlapped with a second end part of the second p-type thermoelectric conversion element included in the second thermoelectric conversion part in the first direction, and
wherein, in the thickness direction, the second thermal conduction part is overlapped with a second end part of the second n-type thermoelectric conversion element included in the second thermoelectric conversion part in the first direction.

8. The thermoelectric conversion module according to claim 7, further comprising:
a first conductive part located on the first main face and connected to one end of the first thermoelectric conversion group in the first direction; and
a second conductive part located on the first main face and connected to the other end of the first thermoelectric conversion group in the first direction and to one end of the second thermoelectric conversion group in the second direction,
wherein each conductivity type of the first conductive part and the second conductive part is identical.

9. The thermoelectric conversion module according to claim 1 or 2,
wherein each of the substrate, the thermoelectric conversion part, the first thermal conduction part, the second thermal conduction part and the thermal insulating member has a flexibility.

10. A method for manufacturing a thermoelectric conversion module, including:
a first step of forming a first thermal conduction part, a second thermal conduction part and a thermal insulating member on one main face of a substrate;
a second step of forming a first layer including a p-type thermoelectric conversion material on the other main face of the substrate;
a third step of forming a p-type thermoelectric conversion layer by immersing the other main face of the substrate in an organic solvent after the second step; and
a fourth step of forming a p-type thermoelectric conversion element and an n-type thermoelectric conversion element in a part of the p-type thermoelectric conversion layer by dripping a dopant solution on the part after the third step,
wherein the first thermal conduction part and the second thermal conduction part are adjacent to each other along a first direction orthogonal to a thickness direction of the substrate,
wherein a first end part of the p-type thermoelectric conversion element in the first direction is in contact with a first end part of the n-type thermoelectric conversion element in the first direction and overlaps with the thermal insulating member in the thickness direction,
wherein, in the thickness direction, the first thermal conduction part is overlapped with a second end part of the p-type thermoelectric conversion element in the first direction,
wherein, in the thickness direction, the second thermal conduction part is overlapped with a second end part of the n-type thermoelectric conversion element in the first direction, and
wherein each of a difference in linear expansion coefficient between the first thermal conduction part and the thermal insulating member and a difference in linear expansion coefficient between the second thermal conduction part and the thermal insulating member is 100 ppm/K or less.
